# EUROPÄISCHE PATENTSCHRIFT

(11) **EP 0 949 757 B1**
(45) Veröffentlichungstag und Bekanntmachung des Hinweises auf die Patenterteilung: **25.02.2004**
(21) Anmeldenummer: 99106740.6
(22) Anmeldetag: 03.04.1999
(51) Int. Cl.: H03J 7/02

(54) **Verfahren und Vorrichtung zur Kompensation von Frequenzabweichungen beim Empfang von Satelliten-Rundfunksignalen mittels einer Satellitenempfangsanlage**
Method and device for frequency drift compensation at reception of satellite broadcasting signals by a satellite receiver
Méthode et dispositif pour la compensation de la dérive fréquentielle à la réception de signaux diffusés par satellite, par un récepteur satellite

(30) Priorität: 09.04.1998 DE 19815953
(43) Veröffentlichungstag der Anmeldung: 13.10.1999
(73) Patentinhaber: GRUNDIG Aktiengesellschaft, 90471 Nürnberg (DE)
(72) Erfinder: Schramm, Günter, 90762 Fürth (DE)

(56) Entgegenhaltungen:
- EP-A- 0 367 214
- EP-A- 0 601 553
- DE-A- 3 920 685
- US-A- 5 532 760

## Beschreibung

Die Erfindung betrifft ein Verfahren zur Kompensation von Frequenzabweichungen beim Empfang von Satelliten-Rundfunksignalen mittels einer Satellitenempfangsanlage mit den im Oberbegriff des Anspruchs 1 angegebenen Merkmalen und eine Vorrichtung mit den im Oberbegriff des Anspruchs 8 angegebenen Merkmalen.

Verfahren und Vorrichtungen zum Empfang von Satelliten-Rundfunksignalen mittels einer Satellitenempfangsanlage sind bereits bekannt. Bei diesen werden die über einen Transponder eines Rundfunksatelliten übertragenen Signale, die in einem Frequenzbereich zwischen 9,75 GHz und 12,75 GHz liegen, von der Außeneinheit der Anlage empfangen und einer ersten Frequenzumsetzung unterworfen. Diese erste Frequenzumsetzung erfolgt in der LNB-Einheit (Low Noise Block Converter) der Außeneinheit und dient zur Erzeugung eines Zwischenfrequenzsignals, welches im Frequenzbereich zwischen 950 MHz und 2.050 MHz liegt. Dieses erste Zwischenfrequenzsignal wird einem Satellitenempfänger zugeführt und in dessen Satellitentuner einer zweiten Frequenzumsetzung unterworfen, deren Zweck im wesentlichen darin besteht, das empfangene Signal für herkömmliche Fernsehempfänger oder Videorecorder geeignet umzusetzen. Im Satellitenempfänger ist üblicherweise ein Mikrocomputer vorgesehen, der zur Steuerung der weiteren Bauteile des Satellitenempfängers und auch der Außeneinheit der Satellitenempfangsanlage vorgesehen ist. Der Satellitenempfänger weist einen Senderspeicher auf, der zur Abspeicherung von Rundfunkprogrammdaten vorgesehen ist Diese Rundfunkprogrammdaten sind beispielsweise Informationen über die zum Empfang des Programms notwendige Antennenposition, die Polarisation, die Mittenfrequenz des zugehörigen Satellitentransponders, den Programmnamen, usw. Sie können entweder vom Benutzer mittels der Bedieneinheit des Empfängers eingegeben oder im Rahmen eines Sendersuchlaufes ermittelt werden.

Beim Betrieb einer derartigen Satellitenempfangsanlage treten unerwünschte Frequenzverschiebungen auf, die insbesondere auf Temperaturschwankungen in der LNB-Einheit zurückzuführen sind. Auch Nichtlinearitäten im Satellitentuner können zu derartigen unerwünschten Frequenzverschiebungen führen.

Die Aufgabe der Erfindung besteht darin, einen Weg aufzuzeigen, wie derartige unerwünschte Frequenzverschiebungen kompensiert werden können.

Diese Aufgabe wird durch ein Verfahren mit den im Anspruch 1 und eine Vorrichtung mit den im Anspruch 8 angegebenen Merkmalen gelöst. Vorteilhafte Ausgestaltungen und Weiterbildungen der Erfindung ergeben sich aus den abhängigen Patentansprüchen.

Die Vorteile der Erfindung ergeben sich aus der Erläuterung eines Ausführungsbeispiels anhand der Figuren. Das Ausführungsbeispiel hat nur beispielhaften Charakter.

Es zeigt:
- FIG 1: ein Blockschaltbild einer Satellitenempfangsanlage und
- FIG 2: ein Diagramm zur Veranschaulichung der unerwünschten Frequenzverschiebungen.

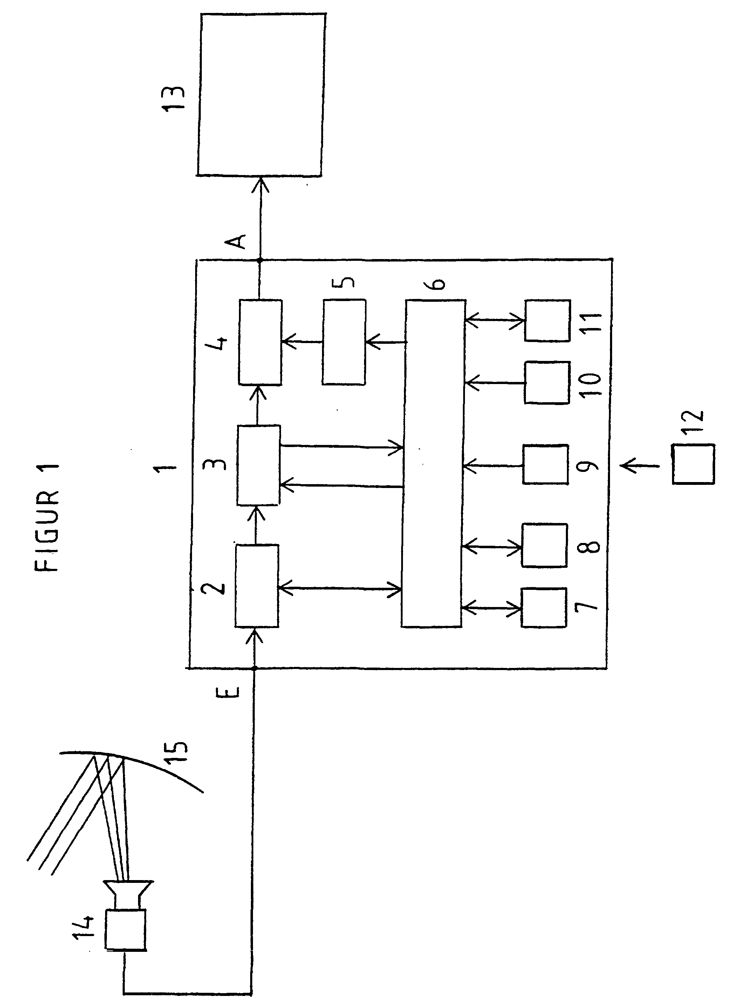

Die Figur 1 zeigt ein Blockschaltbild einer Satellitenempfangsanlage. Diese weist eine Außeneinheit mit einem Parabolspiegel 15 und einer LNB-Einheit 14 auf, in welcher das empfangene Signal einer ersten Frequenzumsetzung unterworfen wird. Das Ausgangssignal der LNB-Einheit 14 wird dem Eingangsanschluß E eines Satellitenempfängers zugeführt, bei dem es sich beispielsweise um eine Set-Top-Box 1 handelt. In einer vorteilhaften Ausgestaltung der Erfindung ist die Set-Top-Box in Form einer digitale Kopfstationscassette oder ein DVB-SAT-Modul eines Fernsehgerätes realisiert. Diese ist zum Empfang von digital übertragenen Satellitenfernsehsignalen vorgesehen. Der Ausgangsanschluß A der Set-Top-Box 1 ist an ein herkömmliches Fernsehgerät 13 angeschlossen. Der Bildschirm des Fernsehgerätes 13 wird zur Darstellung von Femsehsignalen verwendet und dient auch zur Anzeige von Menüseiten und Sendertabellen, die insbesondere im Zusammenhang mit der Belegung des Senderspeichers 11 benötigt werden. Die Set-Top-Box weist weiterhin einen Satellitentuner 2, eine Signalverarbeitungsschaltung 3, eine Eintastschaltung 4, einen Textbaustein 5, einen Mikrocomputer 6, einen Benutzerführungsinformationsspeicher 7, einen Suchlaufspeicher 8, einen Fembedienungsempfänger 9, einen Speicher 10 zur Abspeicherung einer länderspezifischen Sendertabelle, einen Senderspeicher 11 und einen Fernbedienungsgeber 12 auf.

Der Benutzerführungsinformationsspeicher 7, in welchem insbesondere Menüseiten abgespeichert sind, und der Speicher 10 zur Abspeicherung einer länderspezifischen Sendertabelle sind nichtflüchtige Speicher, die bereits bei der Fertigung der Set-Top-Box 1 im Werk mit Daten versehen werden. Zur Veranschaulichung sind in der Figur 1 diese beiden Speicher getrennt gezeichnet. In der Praxis kann es sich bei diesen beiden Speichern auch um einen einzigen Speicherbaustein handeln, der mehrere Speicherbereiche aufweist.

Bei dem Suchlaufspeicher 8 und dem Senderspeicher 11 handelt es sich vorzugsweise um RAM-Speicher, die erst bei der Belegung des Senderspeichers 11 mit Daten versehen werden und deren Speicherinhalt in Ansprache auf Bedienbefehle veränderbar ist. Zur Veranschaulichung sind in der Figur 1 diese beiden Speicher getrennt gezeichnet. In der Praxis kann es sich bei diesen beiden Speichern auch um einen einzigen Speicherbaustein handeln, der mehrere Speicherbereiche aufweist.

Der Mikrocomputer 6 ist zur Steuerung des Satellitentuners 2, der Signalverarbeitungsschaltung 3, der Eintastschaltung 4 und des Textbausteins 5 vorgesehen. Weiterhin dient er bei der Belegung des Senderspeichers 11 als zentrale Steuereinheit, die nach einem in einem ROM abgespeicherten Programm arbeitet.

Die Belegung des Senderspeichers 11 erfolgt im Rahmen eines Sendersuchlaufes, der durch einen mittels des Fembedienungsgebers 12 eingegebenen Bedienbefehl ausgelöst wird. Der Bedienbefehl wird dem Mikrocomputer 6 über den Fembedienungsempfänger 9 zugeführt. Der Mikrocomputer 6 steuert den Satellitentuner 2 derart an, daß dieser einen vorgegebenen Frequenzbereich nach empfangbaren Signalen absucht. Das Vorliegen empfangbarer Signale wird beispielsweise dadurch überprüft, daß dem Mikrocomputer 6 von der Signalverarbeitungsschaltung 3 Signale zugeführt werden, die im Mikrocomputer auf das Vorliegen vorgegebener Kriterien überprüft werden. Wird vom Mikrocomputer 6 erkannt, daß ein erstes empfangbares Signal vorliegt, dann ist der Satellitenempfänger auf ein erstes Rundfunkprogramm abgestimmt. Die Mittenfrequenz des zugehörigen Satellitentransponders wird ermittelt und zusammen mit weiteren Rundfunkprogrammdaten des empfangenen Rundfunkprogrammes im Senderspeicher 11 abgespeichert. Diese abgespeicherte Mittenfrequenz dient - wie unten noch erläutert wird - während des Suchlaufs nach weiteren Sendern bzw. Rundfunkprogrammen als Referenzmittenfrequenz.

Sind die Rundfunkprogrammdaten des eingestellten Rundfunkprogrammes im Senderspeicher 11 abgespeichert, dann wird unter Steuerung durch den Mikrocomputer 6 der Suchlaufvorgang fortgeführt, um den zweiten empfangbaren Sender aufzufinden. Ist dies geschehen, dann wird auch die Mittenfrequenz des Transponders dieses zweiten Senders ermittelt. Da in der Praxis zur Durchführung des Sendersuchlaufes über den gesamten in Frage kommenden Frequenzbereich, ggf. für mehrere Satellitenpositionen und Polarisationsrichtungen, ein Zeitraum von beispielsweise 30 Minuten vergeht, erfolgt in dieser Zeit eine Erhitzung der LNB-Einheit 14. Diese Erhitzung führt dazu, daß der ermittelte Wert für die Mittenfrequenz eine unerwünschte Frequenzabweichung bzw. Frequenzverschiebung aufweist.

Diese unerwünschte Frequenzverschiebung wird dadurch kompensiert, daß unmittelbar nach der Ermittlung der genannten Mittenfrequenz der Satellitentuner 2 erneut auf das erste Rundfunkprogramm abgestimmt wird, was in sehr kurzer Zeit erfolgen kann. Es erfolgt eine erneute Ermittlung der Mittenfrequenz des dem ersten Rundfunkprogramm zugeordneten Transponders. Da dieser ermittelte Wert ebenfalls beim Vorliegen einer bereits erhitzten LNB-Einheit 14 ermittelt wird, weist er ebenfalls im Vergleich zu der abgespeicherten Referenzmittenfrequenz Abweichungen auf, die in Form eines Korrekturfrequenzwertes erfaßt werden. Dies kann durch eine Auswertung der vom Satellitentuner 2 zur Verfügung gestellten, am Frontendbaustein anliegenden, AFC-Spannung erfolgen.

Eine weitere Möglichkeit zur Erfassung der Abweichung besteht darin, daß nach einem Sendersuchlauf nochmals ein Sender kurz angefahren wird und dann die Frequenzabweichung zur vorher ermittelten Mittenfrequenz festgestellt wird. Auf diese Weise wird ebenfalls der Korrekturfrequenzwert erfaßt.

Der ermittelte Korrekturfrequenzwert wird zum bereits ermittelten Mittenfrequenzwert des Transponders des zweiten Senders bzw. Rundfunkprogrammes addiert bzw. von diesem subtrahiert, um einen korrigierten Mittenfrequenzwert für den Transponder, über den das zweite Rundfunkprogramm übertragen wird, zu ermitteln. Dieser korrigierte Mittenfrequenzwert wird zusammen mit den weiteren Rundfunkprogrammdaten des zweiten Rundfunkprogrammes im Senderspeicher 11 abgespeichert.

Ist dies geschehen, dann wird unter Steuerung durch den Mikrocomputer 6 der Suchlaufvorgang fortgesetzt, um weitere empfangbare Sender aufzufinden. Auch dabei erfolgt jeweils eine Bestimmung der Mittenfrequenz des zugehörigen Transponders und eine Kompensation des ermittelten Wertes unter Verwendung des abgespeicherten Referenzmittenwertes des dem ersten Rundfunkprogramm zugehörigen Transponders.

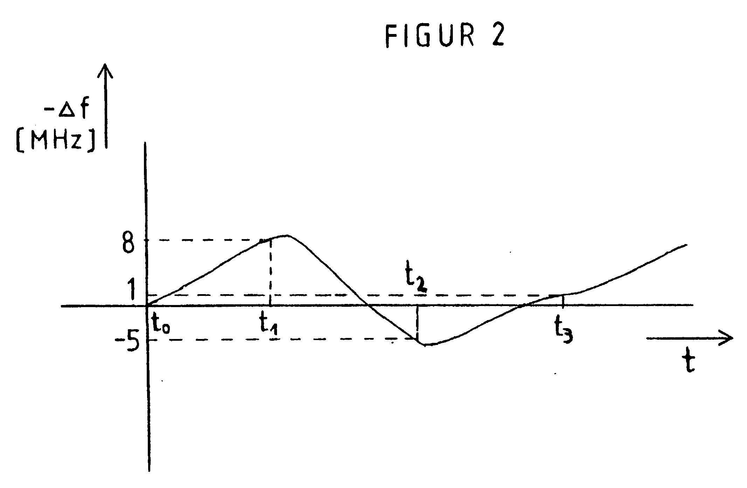

Dies ist in der Figur 2 veranschaulicht, wobei in dieser Figur nach rechts die Zeit und nach oben der ermittelte Korrekturfrequenzwert aufgetragen sind. Das Auffinden des ersten Rundfunkprogrammes geschieht zum Zeitpunkt t₀. Die zu diesem Zeitpunkt ermittelte Mittenfrequenz dient als Referenzmittenfrequenz.

Das zweite Rundfunkprogramm wird zum Zeitpunkt t₁ gefunden. Die ermittelte Frequenzabweichung bzw. der Korrekturfrequenzwert zu diesem Zeitpunkt t₁ beträgt 8 MHz.

Das dritte Rundfunkprogramm wird zum Zeitpunkt t₂ gefunden. Die ermittelte Frequenzabweichung bzw. der Korrekturfrequenzwert zu diesem Zeitpunkt t₂ beträgt -5 MHz.

Das vierte Rundfunkprogramm wird zum Zeitpunkt t₃ gefunden. Die ermittelte Frequenzabweichung bzw. der Korrekturfrequenzwert zu diesem Zeitpunkt t₃ beträgt 1 MHz.

Diese Korrekturfrequenzwerte werden jeweils zum gemessenen Mittenwert addiert bzw. von diesem subtrahiert, um korrigierte Mittenfrequenzwerte zu ermitteln. Die korrigierten Mittenfrequenzwerte der Transponder werden zusammen mit den weiteren Rundfunkprogrammdaten der jeweiligen Rundfunkprogramme im Senderspeicher 11 abgespeichert, wobei ggf. zusätzlich Kriterien berücksichtigt werden, die durch die im Speicher 10 bereits werksseitig abgespeicherte länderspezifische Sendertabelle berücksichtigt wird.

Es ist auch möglich, die gesamte "Mittenfrequenztabelle" nachträglich zum Zwecke einer Kompensation zu normieren. Dies kann notwendig werden bei einem Austausch der LNB-Einheit oder nach Umzügen bzw. wenn vom Händler bereits eine Einstellung im Gerät vorgenommen wurde.

Nach alledem erfolgt bei der vorliegenden Erfindung bei der Abstimmung des Tuners auf ein neues Rundfunkprogramm stets eine Ermittlung unerwünschter Frequenzabweichungen der Mittenfrequenz des jeweils zugehörigen Satellitentransponders, wobei von einer abgespeicherten Referenzmittenfrequenz Gebrauch gemacht wird.

Das vorstehend beschriebene Verfahren ist jedoch nicht nur im Rahmen der Belegung des Senderspeichers mittels eines Sendersuchlaufes verwendbar. Beispielsweise kann es auch beim herkömmlichen Rundfunksignal-Wiedergabebetrieb Anwendung finden, da auch dort bei einer längeren Betriebsdauer die Temperatur in der LNB-Einheit starken Schwankungen unterworfen ist. Weiterhin können mittels des beschriebenen Verfahrens auch Frequenzabweichungen kompensiert werden, die aufgrund von Nichtlinearitäten im Satellitentuner auftreten.

Die Frequenzabweichung von der Mittenfrequenz wird laufend ermittelt, um auf diese Weise die Temperatureinflüsse zu kompensieren. Diese Frequenzabweichung, welche auf die Temperaturdrift der verwendeten Bauelemente und der LNB-Einheit zurückzuführen sind, sind hier für sämtliche Sender gleich. Daher ist die Frequenzabweichung ebenfalls für sämtliche empfangbaren Sender identisch, für oben genannte Einflüße. Bei der Umschaltung auf einen anderen Sender ist folglich zur gespeicherten Mittenfrequenz des Transponders des neuen Senders die Frequenzabweichung zu berücksichtigen. Dies erfolgt bei der vorliegenden Erfindung bereits bei der Umschaltung auf einen neuen Sender.

Im weiteren ist zu berücksichtigen, daß die Nichtlinearitäten im Satellitentuner ebenfalls zu unerwünschten Frequenzverschiebungen führen können. Diese können zumindest teiweise ebenfalls mit dem erfindungsgemäßen Verfahren berücksichtigt und kompensiert werden.

## Patentansprüche

1. Verfahren zur Kompensation von Frequenzabweichungen beim Empfang von Satelliten-Rundfunksignalen mittels einer Satellitenempfangsanlage, bei welchem
- von einer Satellitenantenne (15) empfangene Satellitenrundfunksignale eines über einen Satellitentransponder übertragenen Rundfunkprogramms in einer ersten Umsetzungseinheit (14) in ein erstes Zwischenfrequenzsignal umgesetzt werden,
- das erste Zwischenfrequenzsignal in einem Satellitentuner (2) in ein zweites Zwischenfrequenzsignal umgesetzt wird, und
- durch Auswertung des zweiten Zwischenfrequenzsignals eine Information über die Mittenfrequenz des Satellitentransponders abgeleitet wird,
**dadurch gekennzeichnet, daß**
- in einem ersten Schritt der Satellitentuner (2) auf ein erstes Rundfunkprogramm abgestimmt wird, um die Mittenfrequenz des zugehörigen Satellitentransponders zu ermitteln und als Referenzmittenfrequenz abzuspeichern,
- in einem zweiten Schritt der Satellitentuner (2) auf ein zweites Rundfunkprogramm abgestimmt wird, um die Mittenfrequenz des zugehörigen Satellitentransponders zu ermitteln,
- in einem dritten Schritt der Satellitentuner (2) wieder auf das erste Rundfunkprogramm abgestimmt wird, um aufgetretene Abweichungen von der Referenzmittenfrequenz in Form eines Korrekturfrequenzwertes zu erfassen, und
- in einem vierten Schritt der im zweiten Schritt ermittelte Mittenfrequenzwert mit dem Korrekturfrequenzwert zu beaufschlagen, um Frequenzabweichungen zu kompensieren.

2. Verfahren nach Anspruch 1,
**dadurch gekennzeichnet, daß**
die Abweichung von der Referenzmittenfrequenz bei jedem Senderwechsel und/oder nach vorgegebenen Zeitabständen festgestellt wird, diese Abweichung gespeichert wird und die Abweichung bei jedem Senderwechsel dessen abgespeicherte Mittenfrequenz des zugehörigen Transponders aufgrund der gespeicherten Abweichung modifiziert wird, wodurch die Temperaturdrift der verwendeten Bauelemente des Satelitenempfängers (1), der LNB-Einheit (14) und der Nichtlinearitäten des Satellitenempfängers kompensiert wird.

3. Verfahren nach Anspruch 1 oder 2,
**dadurch gekennzeichnet, daß**
es im Rahmen eines Sendersuchlaufes zur Belegung des Senderspeichers eines Satellitenempfängers (1) durchgeführt wird.

4. Verfahren nach Anspruch 2 oder 3,
**dadurch gekennzeichnet, daß**
der Sendersuchlauf mittels eines Bedienbefehls ausgelöst wird.

5. Verfahren nach einem der vorhergehenden Ansprüche,
**dadurch gekennzeichnet, daß**
es im Rahmen des Rundfunksignal-Wiedergabebetriebes durchgeführt wird.

6. Verfahren nach einem der vorhergehenden Ansprüche,
**dadurch gekennzeichnet, daß**
es zur Kompensation von Frequenzabweichungen durchgeführt wird, die aufgrund von Temperaturveränderungen in der Außeneinheit der Satellitenempfangsanlage auftreten.

7. Verfahren nach einem der vorhergehenden Ansprüche,
**dadurch gekennzeichnet, daß**
es zur Kompensation von Frequenzabweichungen durchgeführt wird, die aufgrund von Nichtlinearitäten im Satellitentuner (2) auftreten.

8. Verfahren nach einem der vorhergehenden Ansprüche,
**dadurch gekennzeichnet, daß**
zur Ermittlung von Mittenfrequenzabweichungen eine Auswertung der vom Satellitentuner (2) zur Verfügung gestellten AFC-Spannung erfolgt.

9. Vorrichtung zur Kompensation von Frequenzabweichungen beim Empfang von Satelliten-Rundfunksignalen mittels einer Satellitenempfangsanlage, mit
- einer Außeneinheit, die einen Antennenspiege (15) und eine erste Umsetzungseinheit (14) aufweist,
- einer Inneneinheit, die einen Satellitenempfänger (1) aufweist, wobei
- der Satellitenempfänger mit einer Bedieneinheit, einem Satellitentuner (2), einem Senderspeicher (11) und einem Mikrocomputer (6) versehen ist,
**dadurch gekennzeichnet, daß**
der Mikrocomputer (6) einen nichtflüchtigen Speicher aufweist, in welchem ein Arbeitsprogramm abgespeichert ist, aufgrund dessen der Mikrocomputer zur Steuerung eines Verfahrens nach einem oder mehreren der Ansprüche 1 bis 8 geeignet ist.

10. Vorrichtung nach Anspruch 9,
**dadurch gekennzeichnet, daß**
der Satellitenempfänger (1) zum Empfang von digitalen Rundfunksignalen vorgesehen ist und/oder der Satellitenempfänger eine Set-Top-Box oder eine Kabelkopfstation oder ein DVB-TV-Gerät ist.

## Claims

1. Method of compensating for frequency deviations when receiving satellite broadcast signale by means of a satellite receiving system, in which method
- satellite broadcast signals, received by a satellite antenna (15), of a broadcast programme transmitted via a satellite transponder are converted into a first intermediate-frequency signal in a first conversion unit (14),
- the first intermediate-frequency signal is converted into a second intermediate-frequency signal in a satellite tuner (2), and
- an information item about the centre frequency of the statellite transponder is derived by evaluating the second intermediate-frequency signal,
**characterized in that**
- in a first step, the satellite tuner (2) is tuned to a first broadcast programme in order to determine the centre frequency of the associated satellite transponder and to store it as reference centre frequency,
- in a second step, the satellite tuner (2) is tuned to a second broadcast programme in order to determine the centre frequency of the associated satellite transponder,
- in a third step, the satellite tuner (2) is again tuned to the first broadcast programme in order to detect deviations that have occurred in the reference centre frequency in the form of a frequency-correction value, and
- in a fourth step, the centre frequency value determined in the second step is acted on by means of the frequency-correction value in order to compensate for frequency deviations.

2. Method according to Claim 1, **characterized in that** the deviation from the reference centre frequency is determined for every station change and/or after specified time intervals, said deviation is stored and the deviation for every station change of its stored centre frequency of the associated transponder is modified on the basis of the stored deviation, thereby compensating for the temperature drift in the components used in the satellite receiver (1), the LNB unit (14) and the non-linearities of the satellite receiver.

3. Method according to Claim 1 or 2, **characterized in that** it is executed within the scope of a station search for the purpose of loading the station memory of a satellite receiver (1).

4. Method according to Claim 2 or 3, **characterized in** chat the station search is initiated by an operating command.

5. Method according to any one of the preceding claims, **characterized in that** it is executed within the scope of the broadcast-signal reproduction mode.

6. Method according to any one of the preceding claims, **characterized in that** it is executed to compensate for frequency deviations that occur as a result of temperature variations in the outdoor unit of the satellite receiving system.

7. Method according to any one of the preceding claims, **characterized** to that it is executed to compensate for frequency deviations that occur as a result of non-linearities in the satellite tuner (2).

8. Method according to any one of the preceding claims, **characterized in that** the AFC voltage made available by the satellite tuner (2) is evaluated to determine the centre-frequency deviations.

9. Device for compensating for frequency deviations when receiving satellite broadcast signals by means of a satellite receiving system, comprising
- an outdoor unit that comprises an antenna mirror (15) and a first conversion unit (14),
- an indoor unit that comprises a satellite receiver (1),
- the satellite receiver being provided with an operating unit, a satellite tuner (2), a station memory (11) and a microcomputer (6),
**characterized in that** the microcomputer (6) comprises a non volatile memory in which a working program is stored, as a result of which the microcomputer is suitable for controlling a method according to one or more of Claims 1 to 8.

10. Device according to Claim 9, **characterized in that** the satellite receiver (1) is provided for the reception of digital broadcast signals and/or the satellite receiver in a set-top box or a cable head station or a DVB TV set.

## Revendications

1. Procédé de compensation d'écarts en fréquence lors de la réception de signaux radio de satellites au moyen d'une installation de réception de satellite, selon lequel
- des signaux radio de satellite, reçus par une antenne de réception de satellite (15), d'un programme radio transmis au moyen d'un transpondeur de satellite, sont convertis dans une première unité da conversion (14) en un premier signal à fréquence intermédiaire,
- le premier signal à fréquence intermédiaire est converti dans un tuner de satellite (2) en un second signal à fréquence intermédiaire, et
- une information concernant la fréquence centrale du transpondeur de satellite est obtenir par évaluation du second signal à fréquence intermédiaire,
**caractérisé en ce que**
- lors d'une première étape, le tuner de satellite (2) est accordé sur un premier programme radio afin de déterminer la fréquence centrale du transpondeur de satellite associé et de la mémoriser en tant que fréquence centrale de référence,
- lors d'une seconde étape, le tuner de satellite (2) est accordé sur un second programme radio pour déterminer la fréquence centrale du transpondeur de satellite associé,
- lors d'une troisième étape, le tuner de satellite (2) est accordé à nouveau sur le premier programme radio pour détecter des écarts apparus par rapport à la fréquence centrale de référence, sous la forme d'une valeur de fréquence de correction, et
- lors d'une quatrième étape, la valeur de la fréquence centrale déterminée lors de la seconde étape est chargée par la valeur de fréquence de correction pour compenser des écarts en fréquence.

2. Procédé selon la revendication 1, **caractérisé en ce que** l'écart par rapport à la fréquence centrale de référence est déterminé lors de chaque changement d'émetteur et/ou au bout d'intervalles de temps prédéterminés, cet écart est mémorisé et lors de chaque changement d'émetteur la fréquence centrale mémorisée du transpondeur associé est modifiée sur la base de l'écart mémorisé, ce qui a pour effet que la dérive de température des composants utilisés du récepteur de satellite (1), de l'unité LNB (14) et des non linéarités du récepteur de satellite est compensée.

3. Procédé selon la revendication 1 ou 2, **caractérisé en ce qu'**il est exécuté dans le cadre d'une recherche d'émetteur pour le remplissage de la mémoire d'émetteur d'un récepteur de satellite (1).

4. Procédé selon la revendication 2 ou 3, **caractérisé en ce que** la recherche d'émetteur est déclenchée au moyeu d'une instruction de commande.

5. Procédé selon l'une des revendications précédentes, **caractérisé en ce qu'**il est exécuté dans le cadre du fonctionnement de reproduction du signal radio.

6. Procédé selon l'une des revendications précédentes, **caractérisé en ce qu'**il est exécuté pour compenser les écarts en fréquence, qui apparaissent sur la base de variations de températures dans l'unité extérieure de l'installation de réception de satellite.

7. Procédé selon l'une des revendications précédentes, **caractérisé en ce qu'**il est exécuté pour compenser des écarts en fréquence, qui apparaissent sur la base de non linéarités dans le turner de satellite (2).

8. Procédé selon l'une des revendications précédentes, **caractérisé en ce qu'**une évaluation de la tension AFC fournie par le tuner de satellite (2) est exécutée pour la détermination d'écarts par rapport à la fréquence centrale.

9. Dispositif pour compenser des écarts en frequence lors de la réception de signaux radio de satellite à l'aide d'une installation de réception du satellite, comportant
- une unité extérieure, qui comporte un miroir d'antenne (15) et une première unité de conversion (14),
- une unité intéreure, qui comporte un récepteur de satellite (1),
- dans lequel le récepteur de satellite est équipé d'une unité de commande, d'un tuner de satellite (1), d'une mémoire d'émetteur (11) et d'un micro-ordinateur (6),
**caractérisé en ce que**
le micro-ordinateur (6) comporte une mémoire non volatile, dans laquelle est mémorisé un programme de travail, sur la base duquel que le micro-ordinateur commande un procédé selon une ou plusieurs des revendications 1 à 8,

10. Dispositif selon la revendication 9, **caractérisé en ce que** le récepteur de satellite (1) est prévu pour la réception de signaux radio numériques et/ou que le récepteur de satellite est un périphérique Web TV ou un poste de tête de câble ou un appareil DVB TV.
